# EUROPEAN PATENT APPLICATION

(11) **EP 1 577 932 A2**
(43) Date of publication of application: **21.09.2005**
(21) Application number: 05003846.2
(22) Date of filing: 23.02.2005
(51) Int. Cl.: H01L 21/20

(54) **Method of manufacturing a semiconductor on a silicon on insulator (SOI) substrate using solid epitaxial regrowth (SPER) and semiconductor device made thereby**

(30) Priority: 16.03.2004 EP 04101078
(71) Applicant: Interuniversitair Microelektronica Centrum, 3001 Leuven (BE); Koninklijke Philips Electronics N.V., 5621 BA Eindhoven (NL)
(72) Inventor: Pawlak, Bartlomiej Jan, 3001 Leuven (BE)
(74) Representative: Bird, Ariane

(57) **Abstract**

Method for producing a semiconductor device comprising:
- providing a device with a monocrystalline semiconductor layer on an insulating layer, characterized by
- providing a mask on said semiconductor layer to provide first shielded portions and first unshielded portions;
- amorphizing said first unshielded portions to yield first amorphized portions of said monocrystalline semiconductor layer;
- implanting a first dopant in said first amorphized portions;
- applying a first solid phase epitaxial regrowth action to said semiconductor device while using said first shielded portions as monocrystalline seeds.

## Description

The present invention relates to a method for producing a semiconductor device comprising:
- providing a device with a monocrystalline semiconductor layer on an insulating layer.

It is presently known to produce semiconductor devices on silicon on insulator (SOI) wafers or substrates. A problem however, may be formation of polycrystalline Si crystals during growing the silicon on the insulator. The formation of polycrystalline crystals can disrupt performance of transistors and other devices produced in the silicon layer on the insulator. In general, this is solved by providing one or more monocrystalline silicon seeds before growing the silicon layer. An example can be found in US-A-5,948,162. A recent development in the manufacture of semiconductor devices is the use of Solid Phase Epitaxial Regrowth (SPER). An example of SPER is provided in US-A-6,063,682. According to this prior art document SPER entails the heating of previously amorphized (or preamorphized) silicon within the range of 550 °C to 650 °C which causes the amorphized silicon to recrystallize to substantially uniform crystallized silicon.

It is an aim of the present invention to provide a manufacturing process for producing semiconductor substrates and devices on SOI while using a SPER technique such that a monocrystalline silicon layer is produced on the insulator.

The invention is therefore characterized by
- providing a mask on said semiconductor layer to provide first shielded portions and first unshielded portions;
- amorphizing said first unshielded portions to yield first amorphized portions of said monocrystalline semiconductor layer;
- implanting a first dopant in said first amorphized portions;
- applying a first solid phase epitaxial regrowth action to said semiconductor device while using said first shielded portions as monocrystalline seeds.

In an embodiment, the method as described above is characterized by, in addition,
- providing a second mask on said semiconductor layer to provide second shielded portions and second unshielded portions, at least some of said second unshielded portions substantially coinciding with said first shielded portions;
- amorphizing said at least some of said second unshielded portions to yield second amorphized portions;
- implanting a second dopant in said second amorphized portions,
- applying a second solid phase epitaxial regrowth action to said semiconductor device.

This invention offers perfect quality, single crystalline silicon after epitaxial regrowth. The technique can be seamlessly integrated into existing semiconductor fabrication processes and is easily applicable on SOI wafers. In particular, the invention can advantageously be used when dealing with thin layers.

Instead of SPER other techniques used for junction formation can be used like Liquid Phase Epitaxial Regrowth or Rapid Thermal Annealing.

The invention will now be explained with reference to the accompanying drawings 1 to 7, which show the different steps in the fabrication of a semiconductor device according to the invention. In the drawings, the same reference numbers refer to same parts.

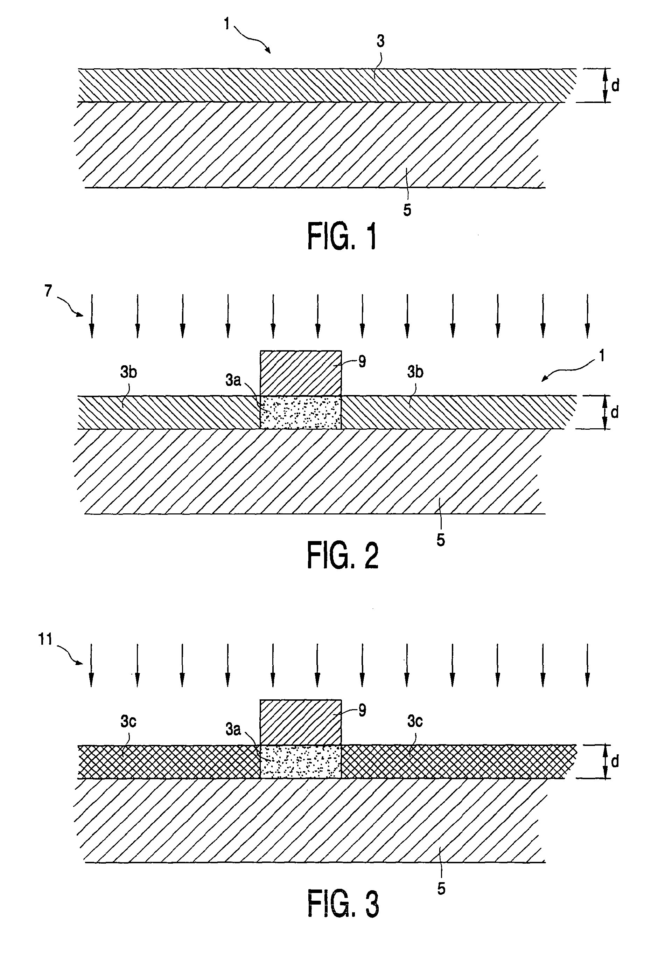

Figure 1 shows a silicon on insulator (SOI)-device 1 as is readily available. The SOI-device 1 comprises a monocrystalline silicon layer 3 formed on an insulating layer 5. The SOI-device 1 may be fabricated by means of any presently known technique, such as epitaxial growth. Below insulating layer 5, there may be provided a substrate (not shown) e.g. made of a semiconductor. The silicon layer 3 has a thickness d.

In figure 2, a first mask 9 is positioned on the monocrystalline silicon layer 3. The assembly of the SOI-device 1 and the first mask 9 is exposed to an implanting action (bombardment) with particles 7. The particles 7 may, for example, comprise at least one of the set comprising Ge, GeF₂ and Si. However, also atoms like xenon (Xe), argon (Ar) or indium (In), arsenic (As), phosphor (P) or ions may be applied. The particles 7 bring about the amorphization of the layer 3. No amorphization, however, takes place where the layer 3 is shielded by the first mask 9. The amorphized portions of the layer 3 are referred to with reference numeral 3b and the portion that remains monocrystalline is referred to with reference numeral 3a in figure 2. The particles 7 will penetrate the entire layer 3b i.e. over the thickness d of the layer 3, up to the interface with the insulating layer 5. The implantation parameters should be chosen appropriately to the desired properties of the active region, junction or transistor channel. However the amorphization parameter should be possibly tuned to produce minimal damage of the Si/SiO₂ interface (i.e. the interface between the silicon layer 3 and the insulating layer 5). Suitable parameters may be Ge at a dose of 10¹⁵ atoms/cm² and an energy of between 2 and 30 keV.

Subsequently, as shown in figure 3, the assembly of SOI-device 1 and first mask 9 is exposed to a dopant action by particles 11. The particles 11 comprise a suitable dopant. The dopant will easily be absorbed in the portion 3b, due to the amorphized nature of the latter. The portion 3b with dopant is referred to with reference numeral 3c in figure 3. On the contrary, limited dopant dose will penetrate the monocrystalline portion 3a. Note that this makes a very sharp and advantageous transition possible between dopant (amorphous) portion 3c and monocrystalline portion 3a.

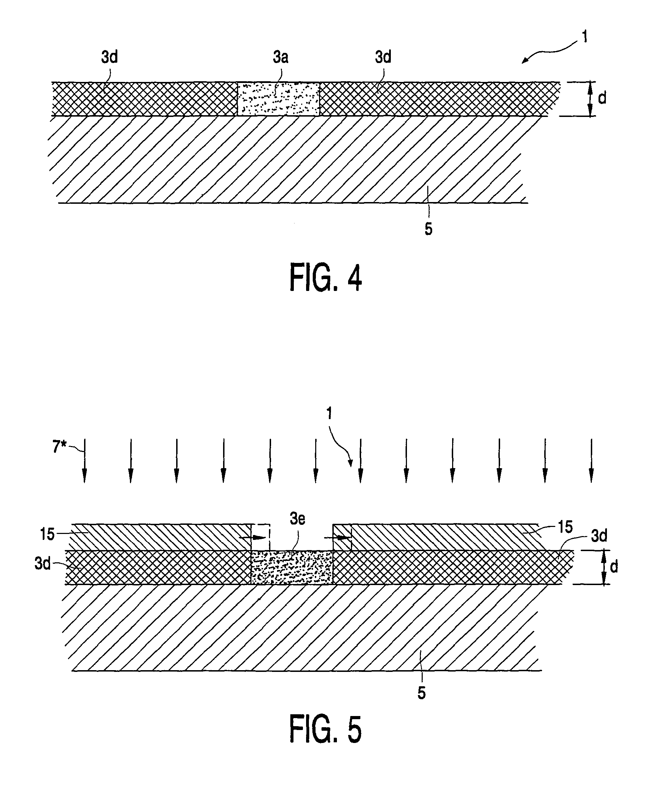

In figure 4, the first mask 9 that was present in the previous process steps is removed. The SOI-device 1 is then annealed. Typical temperatures used vary in between 550 °C and 750 °C during typical times between 1 second and 1 minute. This produces the so called "epitaxial regrowth". The presence of the monocrystalline portion 3a causes the adjacent doped portions 3c of the layer 3 to become monocrystalline as well after annealing. The monocrystalline portion 3a is in this context also referred to as "seed". After annealing, the SOI-device 1 thus comprises a monocrystalline layer 3 again. The doped portions 3c that are now monocrystalline are referred to with reference numeral 3d in figure 4. In a semiconductor device, one of the portions 3d may e.g. function as source and an other as drain.

In figure 5, the (doped, monocrystalline) portions 3d of the SOI-device are covered by a second mask 15. Subsequently, the assembly is again exposed to an implanting action (bombardment) with particles 7* that may be equal to the particles 7 used as described in connection with figure 2 above. This time, as it is not shielded from the particles 7*, the portion 3a of the layer 3 is amorphized. It may be hard to position the second mask 5 exactly over the portions 3d. A slight shift, for instance to the right as indicated by the two small arrows in figure 5, of the second mask 5 relative to the portion 3d may cause amorphization in some part of the latter. In figure 5 this is indicated with a dashed line. Also, some amount of diffusion of the particles 7* under the mask 15 is likely to occur. This will make the transition between amorphous and monocrystalline portions in the layer less abrupt. This diffusion effect also has its influence on the "sharpness" of the transitions between the portion 3a and portion 3b in figure 2. The amorphization of the portion 3a over the entire thickness d of the layer 3 results in the formation of an amorphous portion 3e.

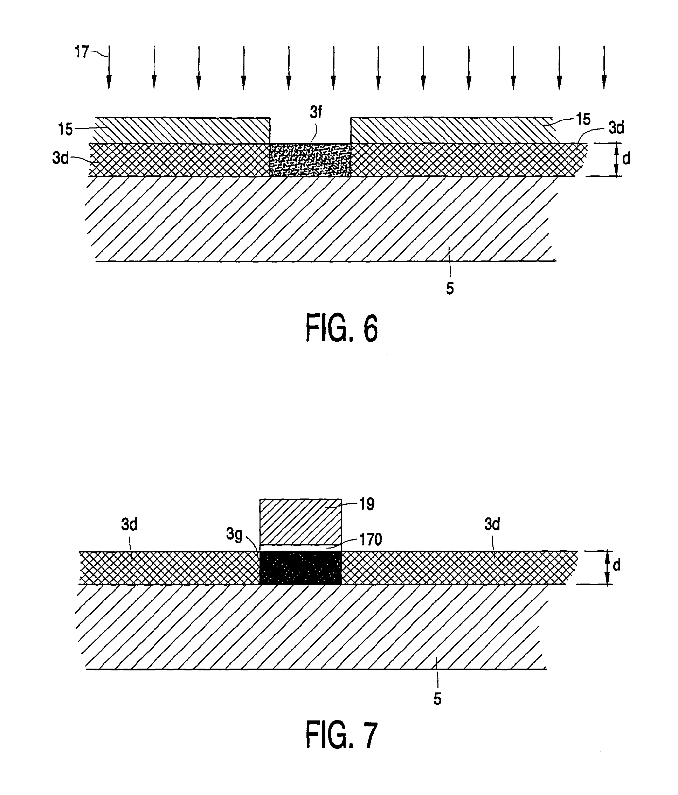

In figure 6 the assembly of SOI-device 1 and second mask 15 is exposed to another dopant action by particles 17. The particles 17 will penetrate the amorphous portion 3e of the layer 3. A doped portion 3f results. This portion 3f is still amorphous.

After removal of the mask 15 the SOI-device is annealed again (epitaxial regrowth). A suitable time period may be around 1 minute and a suitable temperature may be between 550 °C and 750 °C. This time, the monocrystalline portions 3d adjacent to the amorphous portion 3f function as seeds. After annealing the SOI-device 1, a monocrystalline doped portion 3g results from the amorphous portion 3f. This portion 3g is shown in figure 7.Note that, alternatively, the implanting action (bombardment) by particles 7*, as explained in connection with figure 5, and the dopant action by particles 17, as explained in connection with figure 6, may be omitted. The latter is possible if the layer 3 already has the proper type and level of doping.

In figure 7, also a gate oxide 170 deposited on the doped portion 3g is shown. Above the gate oxide 170 a gate 19 is formed. As will be obvious to the person skilled in the arts, suitable connection layers and wires are needed to complete the fabrication of the semiconductor device which may typically be a transistor.

Typical particles used in the dopant action as explained in connection with figure 3 is boron (B) at an energy of less than 5 keV and a dose of 10¹⁵ atoms/cm². In the dopant action of figure 5 phosphor (P) at an energy of less than 70keV and a dose of 1 * 10¹⁴ - 3 * 10¹⁵ atoms/cm². Another option is arsenic (As) at an energy of less than 10 keV at a dose of 1 * 10¹⁴ - 3 * 10¹⁵ atoms/cm². However, any other suitable combination of dopants, as known to persons skilled in the art, may be used. Moreover, other devices than (MOS) transistors may be produced in the SOI-device of figure 3.

The process steps amorphizing and doping, as explained in the above, may be integrated into a single process step if a self-amorphized dopant such as arsenic (As) is used.

Although the present invention has been explained with reference to silicon on insulator, the principles are equally well applicable to other known semiconductor materials on insulator.

## Claims

1. Method for producing a semiconductor device (1) comprising:
- providing a device with a monocrystalline semiconductor layer (3) on an insulating layer (5), **characterized by**
- providing a mask (9) on said semiconductor layer (3) to provide first shielded portions and first unshielded portions;
- amorphizing said first unshielded portions to yield first amorphized portions (3b) of said monocrystalline semiconductor layer (3);
- implanting a first dopant (7) in said first amorphized portions (3b);
- applying a first solid phase epitaxial regrowth action to said semiconductor device (1) while using said first shielded portions as monocrystalline seeds.

2. Method according to claim 1, **characterized by**, in addition,
- providing a second mask (15) on said semiconductor layer (3) to provide second shielded portions and second unshielded portions, at least some of said second unshielded portions substantially coinciding with said first shielded portions;
- amorphizing said at least some of said second unshielded portions to yield second amorphized portions (3e);
- implanting a second dopant (7*) in said second amorphized portions (3e),
- applying a second solid phase epitaxial regrowth action to said semiconductor device (1).

3. Method according to any of the preceding claims, **characterized in that** said semiconductor layer (1) has a thickness of in between 10 nm and 100 nm.

4. Method according to any of the preceding claims, **characterized in that** said insulating layer (5) is silicon dioxide (SiO₂).

5. Method according to any of the preceding claims, **characterized in that** said amorphizing is performed with particles selected from the set of Ge, GeF₂ and Si.

6. Method according to claim 1 to 4, **characterized in that** said amorphizing and said implanting are simultaneously performed with As.

7. Method according to any of the preceding claims, **characterized in that** said first solid phase epitaxial regrowth action includes annealing at a temperature in between 550 °C and 750 °C during a period of 1 second to 1 minute.

8. Method according to any of the claims 2 to 7, **characterized in that** said second solid phase epitaxial regrowth action includes annealing at a temperature in between 550 °C and 750 °C during a period of 1 second to 1 minute.

9. Semiconductor device (1) made by a method according to any of the preceding claims.

10. Apparatus comprising a semiconductor device (1) according to claim 9.
